# FASCICULE DE BREVET EUROPEEN

(11) **EP 3 025 381 B1**
(45) Date de publication et mention de la délivrance du brevet: **06.09.2017**
(21) Numéro de dépôt: 14747098.3
(22) Date de dépôt: 15.07.2014
(51) Int. Cl.: H01L 35/24, H01L 35/34

(54) **PROCEDE DE FABRICATION D'UN MODULE THERMOELECTRIQUE A BASE DE FILM POLYMERE**
VERFAHREN ZUR HERSTELLUNG EINES THERMOELEKTRISCHEN MODULS AUF BASIS EINER POLYMERFOLIE
METHOD FOR MANUFACTURING A THERMOELECTRIC MODULE BASED ON A POLYMER FILM

(30) Priorité: 24.07.2013 FR 1357310
(43) Date de publication de la demande: 01.06.2016
(73) Titulaire: Commissariat à l'Énergie Atomique et aux Énergies Alternatives, 75015 Paris (FR)
(72) Inventeur: MASSONNET, Nicolas, F-38000 Grenoble (FR); CARELLA, Alexandre, F-64110 Mazeres Lezons (FR); SIMONATO, Jean-Pierre, F-38360 Sassenage (FR)
(74) Mandataire: Cabinet Laurent & Charras
(86) Numéro de dépôt international: PCT/FR2014/051806
(87) Numéro de publication internationale: WO 2015/011367

(56) Documents cités:
- FRANCESCO GRECO ET AL: "Ultra-thin conductive free-standing PEDOT/PSS nanofilms", SOFT MATTER, vol. 7, no. 22, 11 octobre 2011 (2011-10-11), page 10642, XP055021468, ISSN: 1744-683X, DOI: 10.1039/c1sm06174g
- FRANCESCO GRECO ET AL: "Sacrificial Layer and Supporting Layer Techniques for the Fabrication of Ultra-Thin Free-Standing PEDOT:PSS Nanosheets", MATERIALS RESEARCH SOCIETY SYMPOSIUM PROCEEDINGS, vol. 1403, 1 janvier 2012 (2012-01-01), - 2 décembre 2011 (2011-12-02), pages 253-256, XP055117859, PITTSBURG, PA; US ISSN: 0272-9172, DOI: 10.1557/opl.2012.252
- G-H. KIM ET AL: "Engineered doping of organic semiconductors for enhanced thermoelectric efficiency", NATURE MATERIALS, vol. 12, no. 8, 5 mai 2013 (2013-05-05), pages 719-723, XP055117860, GB ISSN: 1476-1122, DOI: 10.1038/nmat3635

## Description

### DOMAINE DE L'INVENTION

L'invention concerne la fabrication de modules thermoélectriques, par exemple des capteurs de flux ou des modules de production d'énergie électrique, à base de matériaux polymères.

### ETAT DE LA TECHNIQUE

Les modules thermoélectriques comprennent usuellement une ou plusieurs jonctions thermoélectriques entre deux matériaux, prenant généralement la forme de bandes, ou « pattes », agencées à la surface d'un support électriquement isolant et possédant des coefficients de Seebeck différents. De telles jonctions permettent notamment de produire de l'électricité lors qu'elles sont sujettes à un gradient de température, ou de produire de la chaleur lorsqu'elles sont traversées par un courant électrique. Par exemple, un capteur de flux thermoélectrique permet de mesurer un flux de chaleur unidirectionnel traversant une jonction thermoélectrique en produisant une différence de potentiel dont la valeur dépend de l'intensité du flux de chaleur.

Comme il est connu, par exemple du document « Matériaux à effets thermoélectriques » de C. Godart, Techniques de l'ingénieur, N1500, 1-16, 2009, les matériaux les mieux appropriés pour réaliser des modules thermoélectriques présentant à la fois de bonnes propriétés thermoélectriques, notamment un coefficient de Seebeck et un coefficient de puissance thermoélectrique élevés, une bonne conductivité électrique et une faible conductivité thermique. Les polymères conducteurs ou semi-conducteurs, qui présentent de telles propriétés, ont ainsi été mis en oeuvre dans la réalisation des modules thermoélectriques, notamment le PEDOT:PSS (poly(3,4 éthylène-dioxythiophène), couramment appelé « PEDOT », combiné avec du poly(styrène sulfonate), couramment appelé « PSS »). Notamment, un film polymère entrant dans la constitution d'une jonction thermoélectrique est déposé directement sur le support du module thermoélectrique à l'aide d'une technique de pulvérisation (« *spray* »), de dépôt à la tournette (« *spin coating* ») ou de dépôt à la goutte (« *drop casting* »).

Une telle fabrication présente cependant un certain nombre de désavantages. Tout d'abord, ces techniques de dépôt ne permettent pas de déposer de manière fiable un matériau dès lors que la surface de dépôt n'est pas plane, ce qui limite donc la géométrie que peuvent prendre les modules thermoélectriques. En outre, la réalisation d'un film ayant exactement la géométrie souhaitée directement lors du dépôt nécessite l'utilisation de masques, ce qui s'avère coûteux. De plus, un support de module thermoélectrique n'est pas nécessairement approprié pour le dépôt d'un film polymère. En particulier, si la solution polymère déposée et le support présentent des énergies de surface très différentes, le dépôt s'avère de mauvaise qualité, le module thermoélectrique étant donc fragile. Enfin, des traitements physico-chimiques du film polymère sont parfois nécessaires afin d'optimiser les propriétés de celui-ci. Or, de tels traitements nécessitent notamment l'immersion du film dans un ou plusieurs bains et des étapes de séchage, qui peuvent réduire l'adhérence du film sur le support, voir désolidariser le film du support.

Le document: FRANCESCO GRECO ET AL: "Ultra-thin conductive free-standing PEDOT/PSS nanofilms", SOFT MATTER, vol. 7, no. 22, 11 octobre 2011 (2011-10-11), page 10642 décrit une méthode de fabrication d'un film polymère.

### EXPOSE DE L'INVENTION

Le but de la présente invention est de proposer un procédé de fabrication d'un module thermoélectrique qui permette d'optimiser les propriétés du film polymère et qui permette la réalisation de géométries complexes pour le support du module thermoélectrique et/ou pour le film.

A cet effet, l'invention a pour objet un procédé de fabrication d'un module thermoélectrique comportant un support et un au moins un film polymère conducteur ou semi-conducteur déposé sur une surface du support.

Selon l'invention, la fabrication du film polymère conducteur est réalisée indépendamment de la surface du support et le film polymère conducteur est reporté ensuite sur la surface du support. La fabrication du film polymère conducteur comporte :
▪ le dépôt du film polymère conducteur sur un substrat de dépôt ; et
▪ l'immersion du film polymère conducteur et du substrat de dépôt dans un bain de manière à libérer le film polymère conducteur.
En outre, le report comporte :
▪ l'immersion du film polymère conducteur dans un bain de transfert de manière à obtenir un film polymère conducteur solvaté, auto-supporté et apte à se conformer à la surface du support ;
▪ l'application du film polymère conducteur dans son état solvaté sur le support de manière à se conformer à la surface de celui-ci ; et
▪ le séchage du film polymère conducteur solvaté.

Notamment, le dépôt du film polymère est directement réalisé sur le substrat de dépôt et aucune couche additionnelle n'est prévue pour augmenter la tenue mécanique du film polymère. En particulier, l'empilement uniquement constitué du film polymère et du substrat support est immergé dans le bain de libération du film polymère.

Par « film polymère », on entend ici un matériau entièrement polymère ou un matériau hybride comportant une matrice polymère dans laquelle est ajouté un matériau organique ou inorganique afin notamment d'améliorer les propriétés électriques, chimiques, mécaniques, thermoélectrique et/ou de transfert de chaleur. Par exemple, des éléments métalliques ou semi-conducteurs peuvent être ajoutés. Dans la suite, l'expression « polymère » lorsqu'il désigne un matériau se réfère au polymère en tant que tel, sans matériau d'ajout.

Par « réalisé indépendamment », on entend ici que le film polymère est réalisé sur un substrat différent du support du module thermodynamique sur lequel il est destiné à être reporté. Bien entendu, on comprendra que la géométrie du film polymère peut dépendre de la forme du support.

Par « bain de transfert », on entend ici un liquide qui a la propriété de modifier l'état de solvatation du film polymère en lui conférant la propriété auto-supportée.

En d'autres termes, en réalisant le film polymère indépendamment du support du module thermoélectrique, il est possible d'optimiser ses propriétés en fonction de l'application visée. En outre, il est également possible de définir de manière plus simple et/ou plus précise la géométrie finale que ce dernier doit prendre.

Cependant, on constate que les films polymères sont généralement rigides et cassants une fois séchés. Leur manipulation est donc difficile et plaquer un film polymère dans son état final sec sur un support comporte un risque de casser le film, ce risque étant d'autant plus important que la surface du support n'est pas plane.

Toutefois, lorsque le film polymère est immergé dans un bain dit de « transfert », il présente tout d'abord une modification de sa rigidité en raison d'un phénomène dit de « solvatation ». En retirant le film du bain après une durée d'immersion adéquate, on obtient alors un film solvaté qui est souple et autoporté. Selon l'invention, une fois que le film polymère est fabriqué, il est donc solvaté afin de présenter une souplesse appropriée pour se conformer à la surface du support du module thermoélectrique, et reporté dans son état solvaté sur ledit support. Il peut ainsi être reporté sur un support de géométrique complexe, par exemple un support cylindrique ou un support présentant des angles aigus.

Selon un mode de réalisation de l'invention, la fabrication du film polymère conducteur comporte le dépôt en une seule fois d'une couche d'une épaisseur supérieure à 1 micromètre directement sur le substrat de dépôt, notamment une épaisseur comprise entre 1 micromètre et 100 micromètres. De telles épaisseurs permettent notamment la mise en oeuvre de module thermoélectrique de haute puissance.

Plus particulièrement, la fabrication du film polymère conducteur comporte le dépôt sur le substrat de dépôt d'un film polymère conducteur d'aire supérieure à celle du film polymère conducteur à reporter sur le support du module thermoélectrique, et, consécutivement à l'immersion dans le bain de manière à libérer le film polymère conducteur du substrat de dépôt, le procédé comporte:
▪ le report du film polymère conducteur libéré sur un support de découpe ;
▪ le séchage du film polymère conducteur ;
▪ la découpe du film polymère aux dimensions souhaitées pour celui-ci ; et
▪ l'immersion du film polymère conducteur découpé et du substrat de découpe dans un bain de manière à libérer le film polymère conducteur découpé.

En variante, la fabrication du film polymère conducteur comporte le dépôt sur le substrat de dépôt d'un film polymère conducteur d'aire supérieure à celle du film polymère conducteur à reporter sur le support du module thermoélectrique, et, préalablement à l'immersion dans le bain de manière à libérer le film polymère conducteur du substrat de dépôt, le procédé comporte :
▪ le séchage du film polymère conducteur ; et
▪ la découpe du film polymère de manière aux dimensions souhaitées pour celui-ci.

Avantageusement, le bain de transfert utilisé pour le report est différent du bain pour la fabrication du film polymère conducteur.

Selon un mode de réalisation, le report du film polymère sur la surface du support du module thermoélectrique comporte le positionnement du film polymère conducteur par glissement sur la surface du support.

Selon un mode de réalisation, le séchage du film polymère conducteur comporte le rinçage de celui-ci par un liquide de rinçage de manière à réduire ou éliminer l'état solvaté du film polymère.

Selon un mode de réalisation, le film polymère conducteur comporte un composé aromatique hétérocyclique, notamment un thiophène. Plus particulièrement, le film polymère conducteur comporte du poly-3-hexylthiophène ou du poly(3,4 ethylènedioxythiophène), avantageusement combiné avec du poly(styrène sulfonate) de sodium ou du toluène sulfonate.

Notamment, le bain de transfert utilisé pour le report du film polymère conducteur comporte du diméthylsulfoxyde, ou du n-methylpyrolidonne ou de l'éthylène glycol, ou un alcool, ou de l'eau, ou un composé carbonylé ou un composé organochloré, ou un mélange d'au moins deux de ceux-ci.

### BREVE DESCRIPTION DES FIGURES

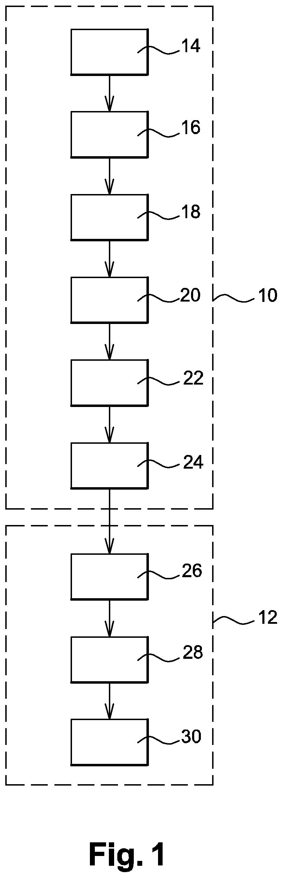

L'invention sera mieux comprise à la lecture de la description qui va suivre, donnée uniquement à titre d'exemple, et réalisée en relation avec l'organigramme de la figure 1 illustrant un procédé de fabrication d'un module thermoélectrique selon l'invention.

### DESCRIPTION DETAILLEE DE L'INVENTION

En se référant à la figure 1, un procédé de fabrication d'un module thermoélectrique selon l'invention comporte une étape **10** de fabrication d'un film polymère conducteur et une étape **12** de report du film sur un support du module thermoélectrique.

Notamment, l'étape **10** de fabrication comporte une étape **16** de synthèse d'un précurseur du matériau organique ou hybride entrant dans la constitution du film en vue de préparer le dépôt du film sur un substrat de dépôt approprié.

La préparation d'un précurseur d'un matériau polymère ou hybride est connue en soi, le précurseur pouvant être une solution, par exemple commerciale, comportant du polymère, ou un monomère de ce dernier, dissout dans un solvant. Le cas échéant, un matériau organique ou inorganique sous forme de poudre est ajouté à, ou est déjà présent dans, la solution du précurseur, ou le matériau d'ajout est dispersé dans un solvant compatible avec la solution du précurseur, puis les deux solutions sont ensuite mélangées.

L'étape **10** de fabrication du film polymère comporte en outre une étape **14** de dépôt de la solution précurseur directement sur un substrat de dépôt, ce dernier étant avantageusement choisi pour favoriser un dépôt de qualité de la solution. Dans le cas où la solution de précurseur comporte des monomères, la polymérisation est avantageusement réalisée sur le substrat

Par exemple, la solution est déposée directement sur le substrat à l'aide d'un dépôt à la goutte, d'un dépôt à la tournette, d'un dépôt par épandage (« *doctor blade* ») ou d'un dépôt de type jet d'encre, en déposant une quantité contrôlée de solution sur la surface du substrat.

Lorsque la solution précurseur est une solution à base de monomères, le procédé se poursuit par l'application en **16** de conditions contrôlées en température, pression, et composition chimique de l'atmosphère afin d'obtenir la polymérisation des monomères, ou dans le cas d'un polymère réticulable par irradiation, une irradiation appropriée est appliquée à la solution déposée. Notamment, la polymérisation des monomères EDOT (3,4 ethylènedioxythiophène) afin d'obtenir du PEDOT est réalisée par électrochimie ou à l'aide d'un espèce oxydante, par exemple un complexe de fer(III) coordonné par des ions para-toluènesulfonates.

En variante, la polymérisation est réalisée avant le dépôt de la solution sur le substrat de dépôt ou bien la solution est déjà polymérisée, comme cela est par exemple le cas de certaines solutions commerciales.

La solution déposée est alors séchée en **18.** Notamment, le solvant contenu dans la solution déposée est évaporé et une étape de recuit entre 20 à 200 °C, préférentiellement de 20 à 100 °C, est optionnellement mise en oeuvre. Le recuit permet notamment un réagencement structural des domaines du polymère, un déploiement des chaînes moléculaires et une amélioration de la conductivité électrique du film polymère déposé. Dans le cas d'un film hybride, le recuit permet également d'améliorer la cohésion entre le matériau d'ajout et la matrice en polymère. Le recuit est en outre avantageusement mis en oeuvre sous atmosphère contrôlée afin de déshydrater le polymère, ce qui permet d'avoir un dépôt bien sec, et/ou permet d'éviter toute oxydation non désirée. Le recuit est par exemple mis en oeuvre dans une étuve dans des conditions de vide à des températures comprises entre 50 et 150 °C pour sécher au maximum le dépôt.

Il est ainsi possible de fabriquer, notamment une seule étape de dépôt, des films polymère conducteur d'une épaisseur allant de 100 nanomètres à 1 centimètre, et de préférence entre 200 nanomètres et 1 millimètre. Notamment, une épaisseur supérieure à 1 micromètre est avantageuse pour des applications à haute puissance du module thermoélectrique.

Plus particulièrement, la fabrication du film polymère ne contient aucun dépôt de couche additionnelle visant à augmenter la tenue mécanique du film.

La fabrication du film polymère se poursuit optionnellement par une étape **20** de traitement visant à améliorer la conductivité électrique du film polymère, notamment d'un facteur 100, et d'améliorer la stabilité chimique.

Plus particulièrement, le substrat de dépôt et le film polymère sont immergés dans un bain afin d'améliorer les propriétés physico-chimiques du dépôt, tel que cela est par exemple décrit dans le document Kim, Y. H.; Sachse, C.; Machala, M. L.; May, C.; Müller-Meskamp, L.; Leo, K. Advanced Functional Materials 2011, 21, 1076-1081. Ce bain permet notamment une réorganisation des chaînes de polymère, accompagnée du départ de certaines espèces chimiques qui étaient nécessaires au dépôt de la solution de précurseur, ou à la polymérisation du matériau, mais sont néfastes pour ses propriétés électriques ou thermoélectriques. Ce type de dopage structural, également désigné par l'expression de « dopage secondaire » pour un polymère, utilise une espèce dopante qui modifie de manière irréversible la conformation des chaînes de polymères, facilitant la génération et le déplacement des charges électriques le long des macromolécules. Ce dopage est par exemple décrit pour la polyaniline dans le document d'Alan McDiarmid et al. [MacDiarmid, A. G.; Epstein, A. J. Synthetic Metals 1995, 69, 85-92.], et pour le PEDOT :PSS dans le livre d'Andreas Elschner et al. [Elschner, A.; Kirchmeyer, S.; Lôvenich, W.; Merker, U.; Reuter, K. PEDOT; CRC Press, 2010., chapitre 9.3 : "Secondary doping*"].*

Le procédé se poursuit alors par la libération du film polymère et optionnellement, par sa mise en forme en fonction de l'application visée.

Notamment, dans une étape **22,** l'empilement uniquement constitué du film polymère et de son substrat de dépôt est immergé dans un bain de manière à désolidariser le film du substrat. Le film flotte alors dans le bain de solvant et, en raison de sa solvatation, il est auto-supporté, c'est-à-dire qu'il peut être manipulé indépendamment de tout support, et peut notamment être récupéré simplement à l'aide d'une pince ou d'un système mécanique similaire. Lorsque le film présente une résistance mécanique faible et qu'il existe un risque de déchirure par pincement, le film peut également être par exemple récupéré sur un nouveau support ou par filtration du bain de solvant. Certains bains utilisés pour obtenir le dopage structural du polymère permettent également de désolidariser le film du substrat, comme par exemple un bain d'éthylène glycol pour le PEDOT :PSS. Dans un tel cas, les étapes **20** et **22** sont confondues.

Optionnellement, dans une étape **24** suivante, le film polymère est mis en forme pour son report ultérieur sur le support du module thermoélectrique. Par exemple, le film polymère est déposé sur une grande surface afin de fabriquer de manière collective plusieurs bandelettes polymère, ou « pattes », entrant dans la constitution du module thermoélectriques, et chaque bandelette est individualisée par découpe. Notamment, le film est récupéré, ou reporté, sur un substrat de découpe, puis est séché afin de présenter une rigidité suffisante pour sa découpe. Une fois le film séché, ce dernier est alors découpé aux dimensions finales souhaitées pour les pattes. Le film découpé et le substrat de découpe sont ensuite immergés dans un bain pour libérer les pattes qui flottent alors librement dans le bain de solvant. La libération est par exemple obtenue en agitant légèrement le substrat dans le bain ou en détachant mécaniquement les pattes de leur substrat en tirant ces dernières de manière à peler le substrat. En variante, le film est coupé directement sur le substrat de dépôt puis les éléments découpés sont libérés par immersion dans un bain de solvant. La première variante présente l'avantage de ne pas abimer le substrat de dépôt qui peut être réutilisé et de présenter un nombre d'étapes plus réduit. La seconde variante permet quant à elle d'être libre dans le choix du support de découpe, et donc également dans les techniques de découpe. Notamment, une découpe aux ciseaux, simple et précise, peut être utilisée.

L'étape **14** de report du film polymère débute optionnellement, en **26,** par la récupération du film polymère et son immersion dans un nouveau bain, dit de « transfert » afin de conférer à ce dernier la solvatation appropriée pour son report sur le support du module thermoélectrique. L'immersion dans le bain utilisé pour désolidariser le film du substrat de dépôt, ou le cas échéant du support de découpe, peut en effet s'avérer insuffisante pour obtenir la souplesse désirée en vue du report du film polymère sur le support du module thermoélectrique. En outre, les liquides utilisés pour les bains peuvent mettre en oeuvre des mécanismes physico-chimiques différents intervenant dans la souplesse du film, mais également dans l'adhérence de ce dernier sur le support du module thermoélectrique.

En choisissant deux bains différents, il est ainsi possible de choisir un bain optimisé pour la libération du film et un bain optimisé pour le report du film sur le support final.

De manière avantageuse, un rinçage et/ou un séchage sont mis en oeuvre après l'immersion dans le bain utilisé pour libérer le film polymère afin de tirer profit au maximum des propriétés du second bain pour le report du film. Un seul bain est cependant également possible, la solvatation obtenue pouvant être satisfaisante pour le report final sur le support du module thermoélectrique. Un second bain peut également être utilisé pour le rinçage du liquide du premier bain.

Le film polymère est ensuite reporté, en **28,** dans son état solvaté sur le support du module thermoélectrique, directement à l'emplacement souhaité pour celui-ci, ou bien glissé sur le support pour son positionnement audit emplacement. L'état solvaté du film polymère permet non seulement de conformer le film à la surface du support, y compris lorsque cette dernière est non plane, mais permet également une adhérence accrue sur le support tout en permettant de glisser le film sur le support, ce qui facilite son positionnement. Lorsque plusieurs pattes, issues par exemple de la découpe du film polymère initial, sont prévues pour le module thermoélectrique, lesdites pattes sont placées à leurs emplacements respectifs.

Le procédé se poursuit par une étape **30** de séchage et de finalisation du module thermoélectrique, mise en oeuvre lorsque le film polymère ou les pattes sont en place sur le support du module thermoélectrique. La mise en oeuvre du séchage et de la finalisation, ainsi que leur enchaînement, peuvent être fonction de la nature du film polymère, de la géométrie du module et du bain utilisé pour régler l'état de solvatation du film polymère. Par exemple, une phase de séchage du film polymère reporté est mise en oeuvre dans des conditions de température et de pression données, notamment au moyen d'un recuit. Par exemple, pour un film de PEDOT:PSS solvaté par immersion dans un bain d'éthylène glycol, une température de recuit comprise entre 50 °C et 200 °C, par exemple 160 °C, à pression ambiante et sous atmosphère ambiante est mise en oeuvre pendant 1 heure. Ces conditions permettent d'obtenir des conductivités électriques comprises entre 1000 et 1600 S/m. Une simple étape de séchage par évaporation, et par conséquent sans mise en oeuvre de recuit, est également possible, par exemple lorsque le second bain est un bain d'éthanol

De préférence, un rinçage par un solvant différent de celui utilisé pour la solvatation en vue du report est mis en oeuvre préalablement au séchage afin d'éliminer les traces du solvant de report, ce qui permet également de fixer la position du film polymère.

Une fois séché, et le cas échéant rincé, le film polymère reste plaqué contre le support et n'est plus auto-supporté. Une phase de compression peut également être mise en oeuvre avant ou après le séchage afin de maximiser le plaquage du film.

Enfin, une étape d'encapsulation du film polymère et du support peut également être mise en oeuvre pour fixer définitivement les films et les protéger contre des dégradations mécaniques ou physico-chimiques telle que l'oxydation par exemple et pour améliorer la tenue mécanique.

Les films polymères pouvant être mis en forme et reportés par le procédé selon l'invention sont tous les matériaux polymères ou hybrides. Par exemple, concernant la partie organique du matériau, il peut s'agir de composés aromatiques hétérocycliques tels que les thiophènes et leurs dérivés, de préférence le P3HT (poly-3-hexylthiophène) et de préférence le PEDOT, ou les polypyrroles et leurs dérivés, les arylamines et leurs dérivés, de préférence le PTA (polytriarylamine), le polyacétylène et ses dérivés, les isochromenones et leurs dérivés, les polyanilines et leurs dérivés, les polyarylènes éthynylènes et leur dérivés, les polyarylènes vinylènes et leurs dérivés, les polycarbazoles, les poly(2,7- carbazolylenevinylene), des macrocycles hétérocycliques tels que les porphyrines, les phtalocyanines et leurs dérivés.

Cette partie organique peut aussi être un polymère isolant, tel que le polyvinyl acétate, le polystyrène, le polyéthylène.

Le matériau d'ajout, lorsqu'il y en a un, peut être de tout type, notamment un matériau inorganique métallique, par exemple des nanoparticules métalliques, tels que des nanoparticules d'or, nanofils métalliques, tels que des nanofils d'argent, des poudres métalliques, telles que des poudres d'indium, de sélénium, ou de plomb, ou un matériau inorganique semi-conducteur, notamment des nanoparticule ou des nanofils de silicium, de germanium, d'oxyde de zinc, de tellure, de bismuth, d'antimoine, ou un alliage de semi-conducteurs, comme par exemple du tellurure de bismuth.

Le matériau d'ajout peut également prendre la forme de nanotubes de carbone de type métalliques ou semi-conducteur, de graphène, ou de fullerène.

Différents solvants peuvent être envisagés, en fonction du polymère considéré, mais aussi des propriétés physico-chimiques souhaitées pour le polymère.

Pour les dérivés des thiophènes, tels que P3HT ou PEDOT, les solvants préférés pour le report de films sont ceux réalisant un dopage secondaire sur le polymère, notamment les polyols (par exemple le glycérol, l'éthylène glycol, le sorbitol et le meso-erythritol), les alcool possédant un groupe polaire secondaire (par exemple le 2-nitroethanol et le méthoxyphenol), les éther-oxydes et thioéthers (par exemple le diéthylène glycol, le thiodiéthanol, et le tétrahydrofurane), les amides et imides (par exemple le N,N-diméthylformamide, le N,N-dimethylacetamide, le N-methylpyrrolidone et le succinimide), les sulfoxydes (par exemple le diméthylsulfoxyde), ou les liquides ioniques (par exemple le 1-butyl-3-méthylimidazolium tetrafluoroborate et le 1-éthyl-3-méthylimidazolium tetracyanoborate).

Le bain utilisé pour le report peut également être un bain usuel tel qu'un alcool (par exemple de l'éthanol, du butanol, ou de l'isopropanol), de l'eau, un composé carbonylé (par exemple de l'acétone ou du butan-2-one), un composé organochloré (par exemple du tricholorométhane ou du dichlorométhane), ou un mélange de ces composés.

L'immersion dans un bain en vue de solvater et/ou libérer le film polymère est préférentiellement réalisée à froid. La durée d'immersion dépend quant à elle de la nature du film polymère, du substrat et du bain, et peut varier entre quelques dizaines de secondes à 1 heure, la durée minimale correspondant à l'instant où le film se désolidarise mécaniquement de son support.

Notamment, lorsque le film polymère est un film de PEDOT :PSS déposé sur un substrat de verre, de plastique ou d'aluminium, une immersion du film et du substrat dans un bain de diméthylsulfoxyde, de n-methylpyrolidonne, ou d'éthylène glycol pendant une durée comprise entre 10 minutes et une semaine permet de désolidariser le film du substrat. On observe que le PEDOT:PSS se désolidarise généralement en 20 minutes. Pour une durée d'immersion supérieure, on constate que les propriétés mécaniques et chimiques du film restent stables, y compris lorsque le film est immergé dans le bain pendant plusieurs semaines.

On note également que le bain utilisé pour désolidariser le film du substrat de dépôt peut également convenir à obtenir l'état solvaté souhaité pour le report sur le support final, comme par exemple un bain d'éthylène glycol.

De plus, une immersion du film de PEDOT:PSS dans un bain d'éthanol pendant une durée comprise entre 1 seconde à 1 heure permet de régler la solvatation du film de manière à faciliter son report sur un support, y compris un support comportant des saillies et des angles à 90°. Notamment, l'immersion dans le bain d'éthanol rend le film plus rigide, et donc plus facile à manipuler, et rince également l'éthylène glycol. La modification de la rigidité du PEDOT :PPS est quasi immédiate. Le rinçage total de l'éthylène glycol nécessite cependant plusieurs minutes d'immersion, généralement 10 minutes.

Le support du module thermoélectrique sur lequel est reporté le film polymère et le support intermédiaire utilisé pour la mise en forme du film sont par exemple en verre, en polymères, éventuellement souples et/ou transparents, tels le PEN (polyethylenenaphtalate), le PET (polyethyleneterephtalate), en textile tissé ou non tissé, en céramique ou en papier. Les supports intermédiaires peuvent aussi être métalliques, par exemple des plaques d'acier ou des feuilles d'aluminium, afin de faciliter les opérations de compression, de découpe ou de mise en forme des pattes du module thermoélectrique.

### Exemple 1 : Module thermoélectrique fabriqué sur une plaque de verre à partir d'une solution de PEDOT:PSS, par exemple la solution commercialisée par la société Heraeus Precious Metals GmbH sous la référence « HERAEUS CLEVIOS PH1000 ».

Un film de PEDOT:PSS est déposé à la goutte sur un substrat de verre de dimension 5,0 x 2,5 cm². Après un dépôt de 0,8 ml de la solution commerciale d'HERAEUS CLEVIOS PH1000, le matériau est laissé trois jours dans les conditions ambiantes de pression et de température. Pour finaliser le séchage, il est ensuite laissé une demi-journée dans une étuve à 100 °C sous vide. Le matériau obtenu est un film de 10 micromètres d'épaisseur de PEDOT:PSS solidaire du substrat en verre.

Le film mince et son substrat de verre sont ensuite placés dans un bain d'éthylène glycol pendant 30 minutes. Le film se désolidarise alors de la plaque de verre et flotte dans le bain indépendamment du substrat. Ce film est récupéré à l'aide d'une pince plate, puis trempé pendant une minute dans un bain d'éthanol afin de diluer l'éthylène glycol rémanent, puis déposé sur une feuille d'aluminium. Le film transféré sur l'aluminium est ensuite passé à l'étuve pendant 30 minutes à 100 °C sous vide.

La feuille d'aluminium et le film de PEDOT:PSS à sa surface sont ensuite découpés au cutter sous forme de bandelettes d'environ 0,25 x 2,5 cm². Ces bandelettes sont plongées à nouveau dans un bain d'éthylène glycol, ce qui a pour effet de désolidariser le PEDOT:PSS de l'aluminium. On récupère donc des bandelettes de PEDOT:PSS d'environ 0,25 x 2,5 cm² et d'épaisseur 10 micromètres.

Ces bandelettes sont trempées pendant une minute dans un bain d'éthanol, puis déposées de manière parallèle sur un support en verre de 5 x 5 cm² formant le support du module thermoélectrique. Ce support est placé à l'étuve à 100 °C sous vide pendant 30 minutes.

La géométrie choisie pour ce module est adéquate pour une source de chaleur centrée sur la plaque de verre. De la laque d'argent est utilisée pour relier les bandelettes, ou « pattes » du module entre elles, créant de ce fait des jonctions électriques entre le PEDOT:PSS, qui est un polymère semi-conducteur de type *p* et la laque d'argent. La laque d'argent est ensuite séchée sur plaque chauffante à 80 °C pendant une heure. Pour finaliser le module, ce dernier est encapsulé, par exemple au moyen de bandes adhésives de Kapton ® pour protéger les pattes du module. Le module est ensuite relié à un multimètre et testé en utilisant le doigt comme source de chaleur. Le coefficient Seebeck mesuré du module ainsi fabriqué est de 120 µV/K.

### Exemple 2 : Module thermoélectrique fabriqué sur un flacon cylindrique en verre à partir d'une solution de PEDOT:PSS, par exemple la solution Heraeus Clevios PH1000.

Un film de PEDOT:PSS est déposé à la goutte sur un substrat de verre de dimensions 5x5 cm². Après un dépôt de 2 ml de la solution commerciale d'HERAEUS CLEVIOS PH1000, le film et son substrat sont laissés cinq jours dans les conditions ambiantes de pression et de température. Pour finaliser le séchage, le film et le support sont ensuite laissés trois jours dans une étuve à 80 °C sous vide. Il est ainsi obtenu un film d'une épaisseur de 10 micromètres de PEDOT:PSS solidaire du substrat en verre.

Ce film sec est découpé en huit lamelles au cutter, directement sur la plaque de verre. La découpe est aisée car le film est bien solidaire de la surface. Les huit lamelles de polymère restent collées à la surface. Le polymère ainsi découpé et son support sont placés dans un bain d'éthylène glycol pendant 30 minutes. Les lamelles se séparent les unes des autres et flottent librement dans le bain. Les lamelles sont alors récupérées une par une à l'aide d'une pince plate et positionnées sur la face latérale d'un flacon en verre cylindrique. Ce flacon avec les lamelles déposées est placé à l'étuve à 120 °C sous vide pendant 12 heures.

Les lamelles, ou « pattes » polymère se retrouvent alors fixées dans la géométrie choisie, à savoir parallèles sur la longueur du pilulier. Un dépôt de laque d'argent commerciale permet de faire la jonction entre les pattes selon un schéma thermoélectrique connu en soi. Les extrémités du module thermoélectrique sont ensuite reliées à un multimètre.

Lorsqu'un liquide (ici de l'eau) à 80 °C est déposée au fond du pilulier, une réponse de 5 mV est enregistrée, ce qui équivaut à un coefficient Seebeck d'environ 90 µV/K pour le module à température ambiante de 25 °C.

### Exemple 3 : Module thermoélectrique fabriqué sur un substrat flexible et adhésif verre à partir d'une solution de PEDOT:PSS, par exemple la solution Heraeus Clevios PH1000.

Un film de PEDOT:PSS est déposé à la goutte sur un substrat de verre de dimensions 1,25x2,5 cm². Après le dépôt de 0,4 ml de la solution commerciale d'HERAEUS CLEVIOS PH1000, le film et le substrat de verre sont laissés deux jours sur une plaque chauffante à 50 °C. Pour finaliser le séchage, le film et le substrat sont ensuite placés 12 heures dans une étuve à 100 °C sous vide. Il est ainsi obtenu un film de 10 micromètres d'épaisseur de PEDOT:PSS solidaire du substrat en verre.

Ce film sec est ensuite découpé en cinq bandes parallèlement à la largeur du substrat en verre à l'aide d'un cutter. Il est ainsi obtenu cinq lamelles d'environ 1,25x0,5 cm solidaires du substrat de dépôt. L'ensemble est ensuite placé dans un bain d'éthylène glycol pendant 30 minutes. Les lamelles se séparent les unes des autres et flottent alors librement dans le bain. Les lamelles sont récupérés une par une à l'aide d'une pince plate et posées sur un papier buvard. Cela a pour effet de sécher en partie chaque lamelle, qui demeure cependant fortement solvatée. Les lamelles sont ensuite transférées depuis le papier buvard sur une bande de scotch Kapton® collée à une plaque d'aluminium. L'ensemble est ensuite rincé à l'éthanol avant d'être placé dans une étuve sous vide à 50°C pendant 3 jours. Il est alors possible de décoller le scotch Kapton® supportant les cinq lamelles de polymère et le replacer sur un autre support, comme un film PEN de 125 µm d'épaisseur, par exemple celui référencé sous la marque TEONEX. Des pistes en laque d'argent sont ensuite déposées entre les lamelles de PEDOT:PSS en respectant les branchements des pattes du module thermoélectrique.

Après câblage à un multimètre, il est possible de mesurer la sensibilité du capteur de flux de chaleur ainsi obtenu en imposant une source de chaleur sur l'un des côtés du Kapton® formant support. On mesure une réponse d'environ 60 µV/K.

### Exemple 4 : Module thermoélectrique entre les faces avant et arrière d'une vitre en verre mise en forme par transfert de films de PEDOT:PSS.

Une solution de PEDOT:PSS dopé par du DMSO est préparée à partir de 5 mL de la solution commerciale d'HERAEUS CLEVIOS SV4 à laquelle est ajouté un volume de 0,5 mL de diméthylsulfoxide. Après une nuit d'agitation magnétique, 3,2 mL de la solution obtenue sont déposés sur une plaque de verre de dimension 5,0 x 5,0 cm². Après une semaine de séchage dans les conditions ambiantes de pression et de température, le matériau est laissé 2 jours dans une étuve sous vide à 80°C. Le matériau obtenu est un film de 10 micromètres d'épaisseur de PEDOT:PSS solidaire du substrat en verre.

Ce film est découpé sous forme de bandelettes de 5 cm de longueur et 0,5 cm de largeur à l'aide d'un cutter, directement sur le substrat de dépôt.

Le film mince et son substrat en verre sont ensuite placés dans un bain d'éthylène glycol et mis à l'agitateur orbitalaire universel pendant 20 minutes. Les lamelles du polymère se détachent spontanément du substrat. Elles sont laissées au repos dans le bain d'éthylène glycol pendant 2 jours.

Ensuite, les lamelles qui flottent indépendamment dans l'éthylène glycol sont récupérées avec une pince de laboratoire, trempées une dizaine de seconde dans un bain d'éthanol et disposées sur un plaque en verre de 10 cm par 10 cm de manière à ce que la moitié de chaque lamelle se situe sur le recto de la plaque. Chaque lamelle, après avoir été grossièrement placée à la surface, est déplacée en la glissant avec un doigt ganté afin de l'ajuster à sa position finale. Toujours à l'aide d'un doigt ganté, les lamelles sont ensuite repliées sur la face arrière et plaquées sur la tranche de manière à ce que chacune d'entre elle fasse la jonction entre la face avant et la face arrière de la plaque de verre.

De la laque d'argent est déposée à l'aide d'un coton-tige afin de relier l'extrémité située au recto de chaque lamelle avec l'extrémité située au verso de la lamelle voisine. Le module thermoélectrique ainsi réalisé délivre une différence de potentiel proportionnelle à la différence de température entre la face avant et la face arrière de la plaque de verre.

## Revendications

1. Procédé de fabrication d'un module thermoélectrique comportant un support et au moins un film polymère conducteur ou semi-conducteur déposé sur une surface du support, le procédé comportant la fabrication (12) du film polymère conducteur indépendamment de la surface du support et le report (14) du film polymère conducteur sur la surface du support, dans lequel la fabrication (12) du film polymère conducteur comporte :
▪ le dépôt (16) du film polymère conducteur directement sur un substrat de dépôt de manière à former un empilement comportant uniquement le film polymère et le substrat de dépôt ; et
▪ l'immersion (22) de l'empilement formé du film polymère conducteur et du substrat de dépôt dans un bain de manière à libérer le film polymère conducteur.
et **caractérisé en ce que** ledit report (14) comporte :
▪ l'immersion (26) du film polymère conducteur dans un bain de transfert de manière à obtenir un film polymère conducteur solvaté, auto-supporté et apte à se conformer à la surface du support ;
▪ l'application (28) du film polymère conducteur dans son état solvaté sur le support de manière à se conformer à la surface de celui-ci ; et
▪ le séchage (30) du film polymère conducteur solvaté.

2. Procédé de fabrication d'un module thermoélectrique selon la revendication 1, ***caractérisé* en ce que** la fabrication (12) du film polymère conducteur comporte le dépôt en une seule fois d'une couche d'une épaisseur supérieure à 1 micromètre directement sur le substrat de dépôt.

3. Procédé de fabrication d'un module thermoélectrique selon la revendication 2, ***caractérisé* en ce que** la fabrication (12) du film polymère conducteur comporte le dépôt (16) sur le substrat de dépôt d'un film polymère conducteur d'aire supérieure à celle du film polymère conducteur à reporter sur le support du module thermoélectrique, et **en ce que**, consécutivement à l'immersion (22) dans le bain de manière à libérer le film polymère conducteur du substrat de dépôt, le procédé comporte (en 24):
▪ le report du film polymère conducteur libéré sur un support de découpe;
▪ le séchage du film polymère conducteur ;
▪ la découpe du film polymère aux dimensions souhaitées pour celui-ci ; et
▪ l'immersion du film polymère conducteur découpé et du substrat de découpe dans un bain de manière à libérer le film polymère conducteur découpé.

4. Procédé de fabrication d'un module thermoélectrique selon la revendication 2, ***caractérisé* en ce que** la fabrication du film polymère conducteur comporte le dépôt sur le substrat de dépôt d'un film polymère conducteur d'aire supérieure à celle du film polymère conducteur à reporter sur le support du module thermoélectrique, et **en ce que**, préalablement à l'immersion dans le bain de manière à libérer le film polymère conducteur du substrat de dépôt, le procédé comporte :
▪ le séchage du film polymère conducteur ; et
▪ la découpe du film polymère aux dimensions souhaitées pour celui-ci.

5. Procédé de fabrication d'un module thermoélectrique selon la revendication 2, 3 ou 4, ***caractérisé* en ce que** le bain de transfert utilisé pour le report est différent du bain mis en oeuvre pour la fabrication du film polymère conducteur.

6. Procédé de fabrication d'un module thermoélectrique selon l'une quelconque des revendications précédentes, ***caractérisé* en ce que** le report (26) du film polymère sur la surface du support du module thermoélectrique comporte le positionnement du film polymère conducteur par glissement sur la surface du support.

7. Procédé de fabrication d'un module thermoélectrique selon l'une quelconque des revendications précédentes, ***caractérisé* en ce que** le séchage (30) du film polymère conducteur comporte le rinçage de celui-ci par un liquide de rinçage de manière à réduire ou éliminer l'état solvaté du film polymère.

8. Procédé de fabrication d'un module thermoélectrique selon l'une quelconque des revendications précédentes, ***caractérisé* en ce que** le film polymère conducteur comporte un composé aromatique hétérocyclique, notamment un thiophène.

9. Procédé de fabrication d'un module thermoélectrique selon la revendication 8, ***caractérisé* en ce que** le film polymère conducteur comporte du poly-3-hexylthiophène ou du poly(3,4 ethylènedioxythiophène), avantageusement combiné avec du poly(styrène sulfonate) de sodium ou du toluène sulfonate.

10. Procédé de fabrication d'un module thermoélectrique selon la revendication 8 ou 9, ***caractérisé* en ce que** le bain de transfert utilisé pour le report du film polymère conducteur comporte du diméthylsulfoxyde, ou du n-methylpyrolidonne ou de l'éthylène glycol, ou un alcool, ou de l'eau, ou un composé carbonylé ou un composé organochloré, ou un mélange d'au moins deux de ceux-ci.

## Patentansprüche

1. Verfahren zur Herstellung eines thermoelektrischen Moduls, das einen Träger und mindestens einen leitfähigen oder Halbleiter-Polymerfilm enthält, der auf einer Oberfläche des Trägers abgeschieden wird, wobei das Verfahren die Herstellung (12) des leitfähigen Polymerfilms unabhängig von der Oberfläche des Träger und die Übertragung (14) des leitfähigen Polymers auf die Trägeroberfläche umfasst, wobei die Herstellung (12) des leitfähigen Polymerfilms umfasst:
▪ das Abscheiden (16) des leitfähigen Polymerfilm auf einem Abscheidesubstrat, so dass ein Stapel gebildet wird, der ausschließlich aus dem leitfähigen Polymerfilm und dem Abscheidesubstrat besteht; und
▪ das Eintauchen (22) des Stapels aus dem leitfähigen Polymerfilm und dem Abscheidesubstrat in einem Bad, um den leitfähigen Polymerfilm zu erhalten, und **dadurch gekennzeichnet, dass** diese Übertragung (14) umfasst:
▪ das Eintauchen (26) des leitfähigen Polymerfilms in ein Übertragungsbad, um einen leitfähigen Polymerfilm zu erhalten, der solvatisiert, selbsttragend und in der Lage ist, sich der Form der Trägeroberfläche anzupassen;
▪ Aufbringen (28) des leitfähigen Polymerfilms in seinen solvatisierten Zustand auf dem Träger, um sich der Form seiner Oberfläche anzupassen;
▪ und Trocknen (30) des solvatisierten leitfähigen Polymerfilms.

2. Verfahren zur Herstellung eines thermoelektrischen Moduls gemäß Anspruch 1, ***dadurch gekennzeichnet, dass*** die Herstellung (12) des leitfähigen Polymerfilms das Abscheiden in einem Arbeitsgang in einer Dicke von mindestens 1 Mikrometer direkt auf dem Abscheidesubstrat umfasst.

3. Verfahren zur Herstellung eines thermoelektrischen Moduls gemäß Anspruch 2, ***dadurch gekennzeichnet, dass*** die Herstellung (12) des leitfähigen Polymerfilms das Abscheiden (16) auf dem Abscheidesubstrat eines leitfähigen Polymerfilms mit einer Fläche, die größer ist als die des leitfähigen Polymerfilms, der auf den Träger des thermoelektrischen Moduls zu übertragen ist, umfasst und dass folgend auf das Eintauchen (22) in das Bad, zum Lösen des leitfähigen Polymerfilms, das Verfahren umfasst (in 24):
▪ das Übertragung des gelösten, leitfähigen Polymerfilms auf eine Schneidunterlage;
▪ das Trocknen des leitfähigen Polymerfilms;
▪ das Zuschneiden des Polymerfilms auf die gewünschten Maße; und
▪ das Eintauchen des zugeschnittenen Polymerfilms und des Schneidsubstrats in ein Bad, um den zugeschnittenen, leitfähigen Polymerfilm zu lösen.

4. Verfahren zur Herstellung eines thermoelektrischen Moduls gemäß Anspruch 2, ***dadurch gekennzeichnet, dass*** die Herstellung des leitfähigen Polymerfilms das Abscheiden eines leitfähigen Polymerfilms auf einem Abscheidesubstrat mit einer Fläche größer als die des leitfähigen Polymerfilms, der auf das Substrat des thermoelektrischen Moduls zu übertragen ist, umfasst und dass vor dem Eintauchen in das Bad, zum Lösen den leitfähigen Polymerfilms auf dem Abscheidesubstrat, wobei das Verfahren umfasst:
▪ das Trocknen des leitfähigen Polymerfilms; und
▪ das Zuschneiden des Polymerfilms auf die gewünschten Maße;

5. Verfahren zur Herstellung eines thermoelektrischen Moduls gemäß Anspruch 2, 3 oder 4 ***dadurch gekennzeichnet, dass*** das zur Übertragung verwendete Bad ein anderes ist, als das Bad, das zur Herstellung des leitfähigen Polymerfilms eingesetzt wird.

6. Verfahren zur Herstellung eines thermoelektrischen Moduls nach einem der vorhergehenden Ansprüche, ***dadurch gekennzeichnet, dass*** die Übertragung (26) des Polymerfilms auf die Oberfläche des Trägers des thermoelektrischen Moduls, den leitfähigen Polymerfilm gleitend auf der Trägeroberfläche zu positionieren umfasst.

7. Verfahren zur Herstellung eines thermoelektrischen Moduls nach einem der vorhergehenden Ansprüche, ***dadurch gekennzeichnet, dass*** das Trocknen (30) des leitfähigen Polymerfilms umfasst, diesen mit einer Spülflüssigkeit zu spülen um den solvatisierten Zustand des Polymerfilms zu verringern oder zu entfernen.

8. Verfahren zur Herstellung eines thermoelektrischen Moduls nach einem der vorhergehenden Ansprüche, ***dadurch gekennzeichnet, dass*** der leitfähige Polymerfilm eine aromatische, heterozyklische Verbindung umfasst, insbesondere ein Thiophen.

9. Verfahren zur Herstellung eines thermoelektrischen Moduls gemäß Anspruch 8, ***dadurch gekennzeichnet, dass*** die Herstellung (12) des leitfähigen P, ***dadurch gekennzeichnet, dass*** der leitfähige Polymerfilm Poly-3- hexylthiophen oder Poly(3,4 ethylendioxythiophen) enthält, am besten kombiniert mit Natrium-Poly(styrensulfonat) oder Toluensulfonat.

10. Verfahren zur Herstellung eines thermoelektrischen Moduls gemäß Anspruch 8 oder 9, ***dadurch gekennzeichnet, dass*** die Herstellung (12) des leitfähigen P, **dadurch gekennzeichnet, dass** das Übertragungsbad für die Übertragung des leitfähigen Polymerfilms Dimethylsulfoxyd, oder n-Methylpyrrolidon oder Ethylenglykol, oder einen Alkohol oder Wasser, oder eine Carbonyl- oder eine chlorierte Kohlenwasserstoffverbindung oder eine Mischung aus mindestens zwei dieser Stoffe enthält.

## Claims

1. A method of manufacturing a thermoelectric module comprising a substrate and at least one conductive or semiconductor polymer film deposited on a surface of the substrate, the method comprising manufacturing (12) the conductive polymer film independently from the surface of the substrate and transferring (14) the conductive polymer film onto the surface of the substrate, in which the manufacturing (12) of the conductive polymer film comprises:
▪ depositing (16) the conductive polymer film directly on a deposition substrate to form a stack only comprising the polymer film and the deposition substrate; and
▪ immersing (22) the stack formed of the conductive polymer film and of the deposition substrate in a bath to release the conductive polymer film,
and **characterized in that** said transfer (14) comprises:
▪ immersing (26) the conductive polymer film in a transfer bath to obtain a conductive polymer film which is solvated, self-supporting, and capable of matching the shape of the substrate surface;
▪ applying (28) the conductive polymer film in its solvated state on the substrate to match the shape of the surface thereof; and
▪ drying (30) the solvated conductive polymer film.

2. The method of manufacturing a thermoelectric module of claim 1, ***characterized* in that** the manufacturing (12) of the conductive polymer film comprising depositing in a single operation a layer having a thickness greater than 1 micrometer directly on the deposition substrate.

3. The thermoelectric module manufacturing method of claim 2, ***characterized* in that** the manufacturing (12) of the conductive polymer film comprises depositing (16) on the deposition substrate a conductive polymer film having an area greater than that of the conductive polymer film to be transferred onto the substrate of the thermoelectric module and **in that**, consecutively to the immersion (22) in the bath to release the conductive polymer film from the deposition substrate, the method comprises (at 24):
▪ transferring the released conductive polymer film onto a cutting substrate;
▪ drying the conductive polymer film;
▪ cutting the polymer film to the dimensions desired for it; and
▪ immersing the cut conductive polymer film and the cutting substrate in a bath to release the cut conductive polymer film.

4. The thermoelectric module manufacturing method of claim 2, ***characterized* in that** the manufacturing of the conductive polymer film comprises depositing on the deposition substrate a conductive polymer film having an area greater than that of the conductive polymer film to be transferred onto the substrate of the thermoelectric module and **in that**, prior to the immersion in the bath to release the conductive polymer film from the deposition substrate, the method comprises:
▪ drying the conductive polymer film; and
▪ cutting the polymer film to the dimensions desired for it.

5. The thermoelectric module manufacturing method of claim 2, 3, or 4, ***characterized* in that** the transfer bath used for the transfer is different from the bath used for the manufacturing of the conductive polymer film.

6. The thermoelectric module manufacturing method of any of the foregoing claims, ***characterized* in that** the transfer (26) of the polymer film onto the surface of the substrate of the thermoelectric module comprises positioning the conductive polymer film by sliding on the substrate surface.

7. The thermoelectric module manufacturing method of any of the foregoing claims, ***characterized* in that** the drying (30) of the conductive polymer film comprises the rinsing thereof with a rinsing fluid to decrease or eliminate the solvated state of the polymer film.

8. The thermoelectric module manufacturing method of any of the foregoing claims, ***characterized* in that** the conductive polymer film comprises a heterocyclic aromatic compound, particularly a thiophene.

9. The thermoelectric module manufacturing method of claim 8, ***characterized* in that** the conductive polymer film comprises poly-3-hexylthiophene or poly(3,4 ethylene dioxythiophene), advantageously combined with poly(styrene sodium sulfonate) or toluene sulfonate.

10. The thermoelectric module manufacturing method of claim 8 or 9, ***characterized* in that** the transfer bath used to transfer the conductive polymer film comprises dimethylsulfoxide or n-methylpyrrolidone or ethylene glycol, or an alcohol or water, or a carbonyl compound or an organochlorine compound, or a mixture of at least two of these.
